**Europäisches Patentamt**

**European Patent Office**

**Office européen des brevets**

(19)

(11) **EP 1 462 816 A2**

(12) # EUROPEAN PATENT APPLICATION

(43) Date of publication:
**29.09.2004 Bulletin 2004/40**

(51) Int Cl.$^7$: **G01R 33/38**

(21) Application number: **04006697.9**

(22) Date of filing: **19.03.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL LT LV MK**

(30) Priority: **24.03.2003 US 393999**
**06.10.2003 US 679596**
**27.10.2003 US 694419**

(71) Applicant: **BRK Wireless Company, Inc.**
**Park Ridge, IL 60068 (US)**

(72) Inventor: **Abele, Manlio**
**New York, NY 10022 (US)**

(74) Representative: **HOFFMANN - EITLE**
**Patent- und Rechtsanwälte**
**Arabellastrasse 4**
**81925 München (DE)**

(54) **C-shaped NMR imaging system**

(57)     An open magnetic structure comprising a conical permanent magnetic structure that generates an NMR imaging field around the head of a patient in a head cavity of the structure, and a transition magnetic structure including a cylindrical magnet connected to the conical magnetic structures that extends the uniform field generated in the head cavity to or near the shoulders of the patient positioned in a larger shoulder cavity. The overall geometry is designed to integrate the magnetic structure in a surgical suite with minimum interference with surgical procedures, which typically involve surgery on the brain of the patient. Methods for improving field uniformity by adding compensation or shimming means is also included. Advantages include improved field uniformity, and reduced weight and size.

FIG. 9

EP 1 462 816 A2

## Description

The invention is directed to an NMR head imaging system using permanent magnets to establish a uniform imaging field.

## BACKGROUND OF INVENTION

The magnetic structure described in this application is designed for NMR head imaging in interventional procedures. Fabrication of such a structure faces conflicting requirements: optimum imaging requirements are achieved with a closed magnetic structure defining a cavity for the patient's head, but surgical requirements are achieved with an open structure where the surgical region can be readily accessed by a surgeon. Other important requirements are to minimize the dimensions and weight of the magnet, make an efficient use of the magnetic material with a maximum strength of the NMR imaging field, and allow access to the head of the patient from the vertical as well as the horizontal direction.

Commercial NMR head imaging systems nowadays employ electromagnetic superconductive coil systems to produce the necessary NMR uniform field in a region of interest that will surround the head of a patient. This has certain disadvantages, which include the restricted area available to the surgeon due to the limited field orientations possible as well as the superconductive support system.

## SUMMARY OF INVENTION

The principal object of the invention is a permanent magnetic structure capable of generating a uniform field for NMR imaging over a region of interest encompassing the head of a patient with a permanent magnetic structure that generates the uniform field and that is open at least at one side allowing access to the head of the patient by a physician for surgical or other medical purposes.

A further object of the invention is a permanent magnetic structure for NMR imaging of a patient's head which minimizes the dimensions and weight of the magnet, makes an efficient use of the magnetic material with a maximum strength of the NMR imaging field, and allows access to the head of the patient from the vertical as well as the horizontal direction.

These objects are achieved in accordance with one aspect of the invention by a structure of the magnet comprising the combination of a first conical magnetic structure or section of a conical magnet that contributes to generating the NMR imaging field around the head of the patient, and an adjacent second magnetic structure configured to surround the shoulders of the patient. The overall geometry is designed to integrate the magnetic structure in a surgical suite with a minimum interference with the surgical procedures, which typically involves surgery on the brain of the patient.

In a preferred embodiment, the magnetic structure of the invention comprises a first head structure generating a substantially uniform magnetic field in a region of interest encompassing the patient's head, coaxially aligned with a shoulder structure generating a magnetic field that extends the uniform field into a second region encompassing the patient's shoulder which assists in maintaining the substantially uniform magnetic field in the region of interest.

In a further preferred embodiment, the conical section is hollow and is connected to an inner essentially cylindrical section, and the region inside the conical magnet comprises a high-permeability ferromagnetic material.

In still a further preferred embodiment, the magnetic structure comprises opposed, spaced circular-symmetric structures with the region of interest falling within a cavity between the circular-symmetric structures and a second larger outer cylindrical magnet that extends at least in part over each of the circular-symmetric structures. The main permanent magnetic components of the structure of the preferred embodiment are all magnetized in the same direction, preferably parallel to the axis of the conical section.

In another preferred embodiment, the inner essentially cylindrical section is more closely coupled to the conical section. This may introduce field distortions in or near the region of interest. Transition means where the inner cylindrical section and conical section interface are provided to correct for any such field distortions.

In still another preferred embodiment, the inner essentially cylindrical section is essentially integrated with the conical section with at least one magnetic strap positioned to extend radially within the inner essentially cylindrical section to force surfaces intended to be equipotential to become more equipotential. In accordance with another preferred aspect of this embodiment, the magnetic strap extends up to but spaced from the inner surface of the conical section. In this and others of the preferred embodiments, a further improvement is possible by adjusting the value of the design factor K to, typically, a value slightly larger than the factor originally used in the design, in accordance with a method feature of the invention. In still another preferred embodiment, a further improvement is possible by use of a novel shimming technique based on the measurement of the active field generated by the assembled magnetic structure.

In still a further preferred embodiment, the inner ferromagnetic filling of the magnetic conical section is recessed to incorporate an inwardly extending section of the second outer cylindrical magnet, which reduces the weight and size of the overall magnetic structure.

Another preferred embodiment of the invention is based on the surprising discovery that it is possible to configure the inner curved surface of the permanent magnetic section such that an equipotential surface is present at that surface. The important consequence of this discovery is that the adjacent outer surface of the pole piece can be placed in direct contact with that inner curved surface without disturbing the necessary magnetic conditions to ensure the kind of uniform magnetic field needed in the region of interest for NMR imaging. Moreover, it also means that that permanent magnetic section can be constructed as a single integral body which greatly simplifies fabrication of the overall magnetic system.

In accordance with a further aspect of the invention, the outer permanent magnetic section that overlays the pole piece and the inner permanent magnetic section, which can now be integral with the latter, is provided with an axially aligned non-magnetic section at its center and positioned to maintain the desired field uniformity.

The various features of novelty which characterize the invention are pointed out with particularity in the claims annexed to and forming a part of this disclosure. For a better understanding of the invention, its operating advantages and specific objects attained by its use, reference should be had to the accompanying drawings and descriptive matter in which there are illustrated and described preferred embodiments of the present invention, like reference numerals or letters signifying the same or similar components.

## SUMMARY OF THE DRAWINGS

In the drawings:

Fig. 1 is a schematic perspective view of a conical magnetic structure to explain several of the principles on which the invention is based;
Fig. 2 illustrates some exemplary equipotential surfaces present in the structure of Fig. 1;

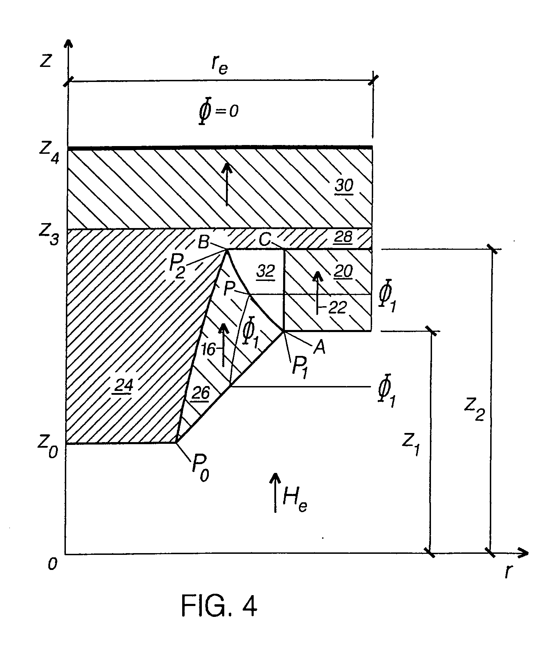

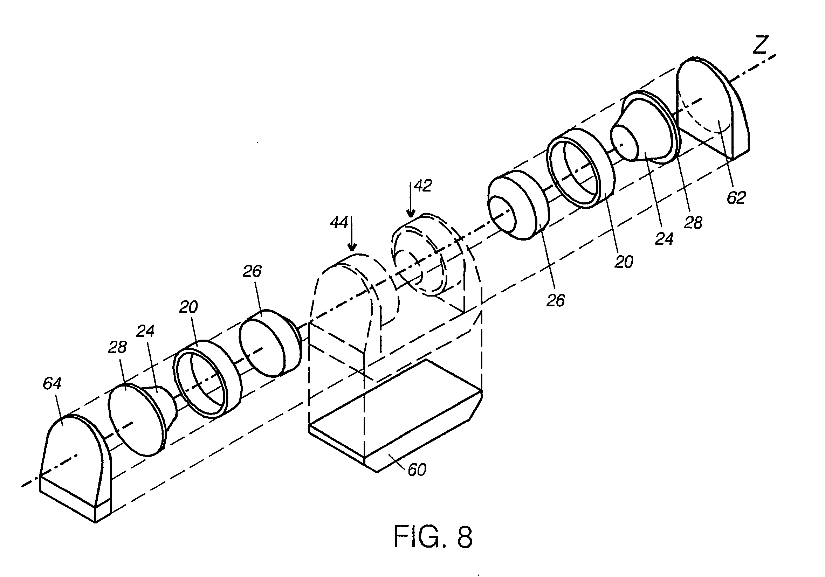

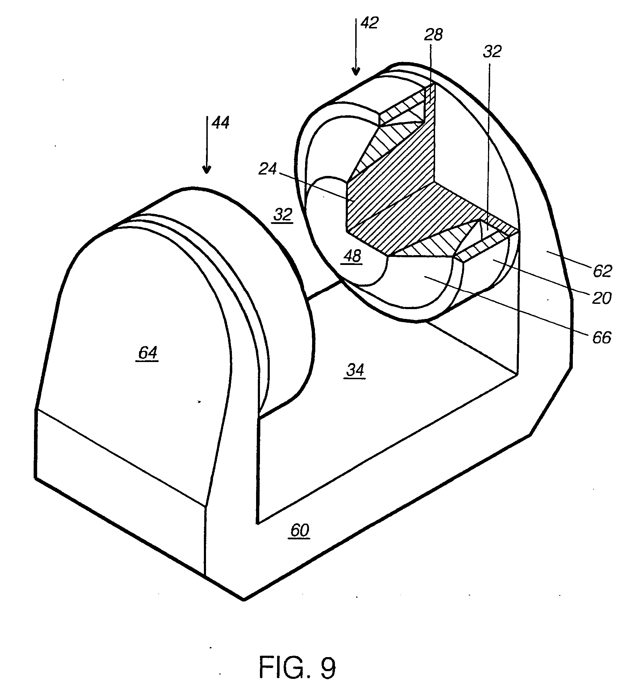

Fig. 3 is a cross-sectional view of part of one embodiment of magnetic structure in accordance with the invention. In this figure and in several of the other figures, only one quarter of the actual structure is shown, as the remaining three quarters are essentially mirror images. In particular, a mirror image of that quarter is present on the opposite side of the vertical axis which if present would illustrate the top half of the full structure, and, similarly, a mirror image of that top half is present on the opposite side of the horizontal axis which if present would illustrate both the top and bottom halves and thus the full structure in accordance with the invention. One embodiment of the full structure according to the invention is illustrated in Figs. 8 and 9. It will be apparent from the figures which ones represent only part of the full structure;
Fig. 4 is a cross-sectional view of part of another embodiment of a magnetic structure in accordance with the invention and Fig. 5 is a similar view with some typical dimensions indicated;

Fig. 6 is a top view of the full magnetic structure of the embodiment of Fig. 4 of which only one-quarter was previously illustrated and to which a yoke has been added. In this figure, a patient is schematically shown;
Fig. 7 is a side view of the magnetic structure shown in Fig. 6;
Fig. 8 is an exploded view of a magnetic structure similar to that of Fig. 7;
Fig. 9 is a perspective view of the Fig. 8 embodiment with one-quarter cut away to show the interior in part.
Fig. 10 is a schematic cross section of part of the magnetic structure of Fig. 7 illustrating the location of one form of a filter structure to compensate field distortions;
Fig. 11 is a cross-sectional view similar to that of Fig. 4 of part of another embodiment of a magnetic structure in accordance with the present invention;
Fig. 12 is a schematic view of another form of magnetic structure in accordance with the present invention;
Fig. 13 is a graph of the field homogeneity and field intensity in the cavity as a function of increases in the design factor K, indicating a method for optimizing these magnetic properties;
Fig. 14 is a cross-sectional view similar to that of Fig. 11 of part of another embodiment of a magnetic structure in accordance with the present invention;
Fig. 15 is an enlarged view similar to a permanent magnetic part of Fig. 7 illustrating a novel shimming technique in accordance with the present invention;
Fig. 16 illustrates the generation of a gap between pole pieces that will ultimately include the region of interest;
Fig. 17 is a simplified version of the Fig. 16 embodiment;
Fig. 18 is a cross-sectional view of part of still another embodiment of a magnetic structure in accordance with the present invention;
Fig. 19 shows four r-axis and z-axis field plots for increasing the number of segments indicated by N that approximate the equipotential surface represented in Fig. 18 by line C1-C10;
Fig. 20 is an exploded view of the magnetic structure resulting from the expansion of Fig. 18 in the four quadrants;
Fig. 21 is a perspective view of the Fig. 20 embodiment with one-quarter cut away to show the interior in part.

## DETAILED DESCRIPTION OF PREFERRED EMBODIMIENTS

For a better understanding of the present invention, the reader is urged to read the many technical papers which I alone or with others published and which describe various configurations of NMR imaging systems as well as various schemes for compensating for magnetic field disturbances in composite structures that have been characterized as yoked, yokeless, or hybrid magnets. Particular attention is directed to issued USPs 5,495,222; 5,790,006, and 6,265,959 which describe some of the problems of fabricating open magnetic structures with NMR imaging uniform fields and some solutions to those problems, the contents of which patents and publications are herein incorporated by reference.

It will also help to present some definitions of terms used herein to avoid ambiguity. These definitions include the following.

A "high permeability" member, as used herein, shall mean a soft ferromagnetic body having a permeability, $\mu$, generally exceeding 10 and preferably as high as possible. For simplicity, it is sometimes referred to in the literature as a ($\mu=\infty$) material, i.e., an ideal soft ferromagnetic body. For virtually all practical purposes, the performance of infinite permeability, unsaturated ferromagnetic material is the equivalent of soft iron.

A "yoked magnetic system", as used herein, is a permanent magnetic structure surrounded by a body of high permeability material serving as a yoke to carry the return flux of the induction B from one pole of the magnetic structure to the other pole. To avoid saturation, the yoke should have a large enough cross sectional area to convey the flux without saturating. The cross section typically varies to satisfy local flux-carrying requirements.

A "hybrid magnetic system", as used herein, is a permanent magnetic structure only partially surrounded by a body of high permeability material, both the high permeability material where present and the non-surrounded parts of the structure serving to carry the return flux of the induction B from one pole of the magnetic structure to the other pole. To avoid saturation, the body of high permeability material which can also be called a yoke should have a large enough cross sectional area to convey the flux without saturating. The yoke cross section typically varies to satisfy local flux-carrying requirements.

A "substantially uniform magnetic field", as used herein, shall mean a magnetic field that over a region of interest has an intensity that varies by less than about 10 ppm or can be "tuned" to that degree of uniformity. It will be evident to those skilled in this art that the magnetic structures described herein may not by themselves produce the desired field uniformity and may leave field distortions that detract from the desired value, but these field distortions are sufficiently small that they can be commonly compensated by a known process called "tuning", using, for example, shims to adjust the positions or values of the magnetic members, and/or filters for field non-uniformities that will produce that degree of uniformity that is desired for adequate NMR imaging.

A "magnetic dipole", as used herein, is a permanent magnetic element with a north pole on one end or side and a south pole at its opposite end or side. It can have various shapes. It can, for example, be a small chunk or block or plate typically mounted on a surface bounding the region of interest. For the conical geometry, the preferred magnetic dipole shape is a ring element surrounding and mounted on the conical surface of the permanent magnetic conical element of the structure.

A "magnetic strap", as used herein, is a thin high permeability layer, only thick enough to prevent saturation, that forces the facing contacted surfaces of adjacent magnetic segments to follow equipotential lines or surfaces. Magnetic straps are described in more detail, for example, in US Patent 5,798,680, the contents of which are herein incorporated by reference.

The term "substantially" appears from time to time in the specification and claims. It should be understood in a practical sense to mean small variations in some structure or parameter term that do not make significant changes in properties associated with those structures or parameters and are included within the scope of the associated term.

The term "essentially" appears from time to time in the specification and claims. It should be understood in a practical sense to mean that it defines a structure which functionally can be characterized in a certain way but in which other aspects of the structure may be present that do not strictly conform to the sense used but also do not significantly detract from its prime or essential function. For example, a magnet may be referred to as essentially cylindrical, when in fact it may have non-cylindrical portions. But for design purposes, the magnet can still be characterized as cylindrical as the latter term signifies its main functional attributes.

Magnetic systems of this kind are often designed using a so-called non-dimensional number identified by the symbol K, which can vary between 0 and 1. Typically, one starts the design with a chosen value for K depending upon the magnetic materials available and the field intensity desired, and this value ofK remains unchanged. However, in accordance with a feature of the present invention, it turns out that relatively small changes in the value for K can have a significant effect on field uniformity, as will be explained below. It will also be understood that permanent magnetic materials having the highest magnetic properties including remanence are preferred. Nowadays, these are the family of rare earth magnets such as Nd,B,Fe. Variations in the relative proportions of the main ingredients of such magnets, as is well known in the art, typically results in variations of the alloys main magnetic properties, a fact that may be used to implement the above feature of the invention.

When the application speaks of "configuring" the magnetic structure, this is to be understood in the context of this and the referenced literature to mean the design scheme of selecting the geometry, dimensions, materials, and magnetizations of the various members of the structure in the light of the design parameter K chosen and such additional constraints as the desired active field intensity, maintenance of field uniformity, and reduction of stray fields.

Open magnetic structures used to implement NMR imaging are often constructed of blocks of permanent magnetic material assembled to form the configuration of the sides, top, and bottom of the structure desired and defining a cavity on its interior for receiving the patient. This is typically a simpler scheme for fabricating such systems as regularly shaped blocks uniformly magnetized in a single direction are easier to fabricate by the usual powder metallurgy and grinding steps. Thus, where the specification or claims call for, for example, a conical or cylindrical-shaped magnetic structure, this should be understood to include a single member with that configuration, or several members held together by magnetic forces forming a composite member with that configuration, since, magnetically speaking, the performance is substantially the same. Moreover, though the magnetic shapes used to illustrate the invention are typically shown with smooth surfaces, in many cases the structure configuration could be implemented with several joined magnetic members which together produce a functional equivalent. For example, the round surface of a conical or cylindrical configuration can sometimes be more easily obtained with a composite structure made up of thin round slabs of permanent magnetic material which form a slightly stepped outer surface. The composite structure, overall, would still be classified as conical or cylindrical, as the case may be, and the resultant orientation of their magnetic fields can still be represented by a single arrow. For convenience, it may also be simpler to define the system using an arbitrary rectangular or spherical coordinate system, in which, as shown in the literature referenced, linear dimensions of the rectangular system coordinate system are measured along the x, y or z dimension, and the corresponding dimensions of the spherical coordinate system are measured along radii and by angles from arbitrary lines or planes. Also, for convenience of explanation, in the preferred embodiment which is analyzed in the spherical coordinate system, the direction of the uniform field is chosen parallel to the z axis which happens to be the cone axis also, and the patient's orientation is chosen such that his or her longitudinal axis is perpendicular to the z axis, so that, when the patient is within the magnetic structure for head imaging in a normal position flat on his or her back, his or her body stretches in a direction perpendicular to the z direction, and thus perpendicular to the direction of the uniform field at the plane of the body. The patient would normally lie on a non-magnetic table within the system, but for convenience the table is not shown in the drawings as it has no effect on the magnetic properties. The spherical coordinate system is indicated in the drawings. The description of the invention focuses on the magnetic structure in the vicinity of the head and shoulders of the patient.

It will also be understood that, in practical situations, normal manufacturing tolerances both in dimensions as well as in magnetic properties of the magnetic blocks introduce minor field distortions and fluctuations which are commonly compensated by a known process called "tuning", for example, using shims to adjust the positions or values of the magnetic members, and filters for field non-uniformities. Also, in the drawings, arrows are present labeled with a J or H, where J is the standard symbol for remanence, H the standard symbol for the magnitude of the uniform field, and $\mu$ the standard symbol for magnetic permeability.

The concepts underlying the development of the invention involve one or more of the following recognitions.

1. A substantially uniform magnetic field capable of implementing NMR imaging can be generated in a cavity by a conical structure defining an inner conical section and a coaxial outer conical section positioned adjacent the cavity, with selected cone angles.

2. The conical shape provides a small cavity connected to an adjacent larger cavity, in which the small cavity can be configured to accommodate the head of an average patient, and the adjacent larger cavity can be configured to accommodate the shoulders of the patient.

3. The outer conical section comprises permanent magnetic material and the inner conical section comprises high permeability magnetic material.

4. It is also desirable to provide a substantially uniform field capable of implementing NMR imaging by extending laterally the outer cone magnet by an additional first permanent magnet section (sometimes referred to as the inner cylindrical permanent magnet), with both permanent magnet members having their remanences oriented in the same direction which is the axis of symmetry of the overall structure and also the orientation of the uniform field in the cavity.

5. The strength of the uniform field can be augmented by positioning an additional second permanent magnet section on the outside of the conical structure, i.e., adjacent the wide end of the conical structure, (sometimes referred to as the outer cylindrical permanent magnet) with its remanence oriented in the same direction as that of the additional first permanent magnet.

In implementing the principles described above, a number of different configurations of magnetized material and soft ferromagnetic materials may be used. Preferred configurations will be described in detail below, but it will be understood that the invention is not limited to those particular configurations and dimensions where indicated and other different combinations of magnetic materials and of other dimensions can be employed following the principles described below to achieve the benefits of the invention, as will be understood by those skilled in this art.

The reader's attention is directed to the attached Appendix A and Appendix B which are a more rigorous mathematical explanation of principles on which the present invention is based and the derivation of the various embodiments disclosed. The following description will focus on the structural arrangements. For more details of how to implement embodiments of the invention, the reader is urged also to review the Appendices whose full contents are herein incorporated by reference as supplemented by any referenced papers and patents.

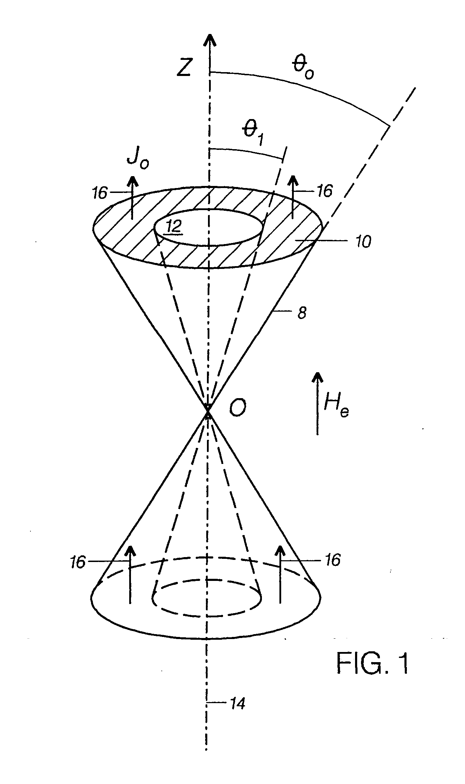

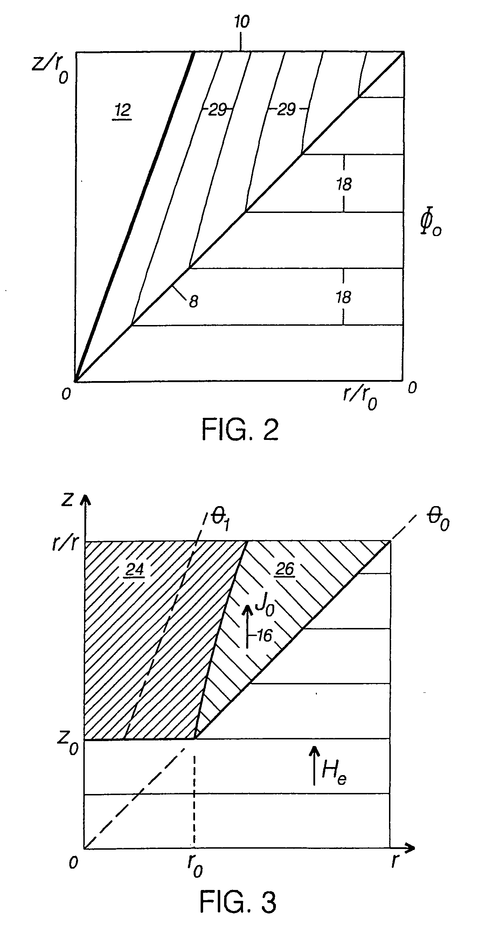

The invention can be better understood in the context of the simple conical structure illustrated in Fig. 1 comprising two coaxial conical sections 10, 12 having a common cone axis 14 also designated as the z axis. The conical structure at the top has an apex at the center labeled 0 which is also the apex of the symmetrical inverted conical structure at the bottom. The outer cone 10 is shown cross hatched for clarity and is contained between half-angle $\theta_0$ and half-angle $\theta_1$ . The outer cone 10 is shown magnetized uniformly with the remanence 16 oriented vertically as shown parallel to the z axis. The inner cone 12 is shown without hatching for clarity and is assumed to be ferromagnetic with a high permeability. Outside of the cone's outer conical surfaces 8 is a non-magnetic medium. As explained in Appendix A, there will be formed adjacent the cone 10 a uniform magnetic field that is also oriented parallel to the z-axis. The equipotential lines for the region adjacent the right side 8 of the upper cone magnet 10 is indicated at 18 in Fig. 2, and the equipotential lines inside the magnet 10 is indicated at 29. For the example given later on, to which the invention is not limited, the conical structure of Fig. 1 generates a uniform field of intensity approximately equal to 0.55 Tesla.

The next step in the development is to maintain the conical magnet shape but eliminate the magnetic material below $Z_0$ as shown in Fig. 3, and, as explained in Appendix A, provide an external termination of the conical body of magnetized material, which is accomplished by the transition from the conical magnetic structure 26 to an annular cylindrical structure 20 as illustrated in Fig. 4 (previously referred to as the additional first or inner permanent magnetic member). The latter has a common axis along the z-axis and is oriented with its remanence 22 also parallel to the z-axis. Other changes are necessary as indicated and explained in the Appendix. The inner now-truncated ferromagnetic conical section 24 bounds as before the magnetized conical section 26 with the remanence 16 also parallel to the z-axis. A horizontal extension 28 of the ferromagnetic section 24 separates the conical section 26 and the cylindrical section 20 from an additional outer cylindrical magnetized body 30 (previously referred to as the additional second permanent magnetic member) which extends over and around the whole structure including the not-shown left quadrant and the not-shown two quadrants below. A non-magnetic or empty space 32 separates the conical 26 and the cylindrical 20 sections. The uniform magnetic field in the non-magnetic space 32 is oriented vertically downward, opposite to the orientation of the field in the adjacent magnetic components 20, 26. The various symbols are explained in the Appendix.

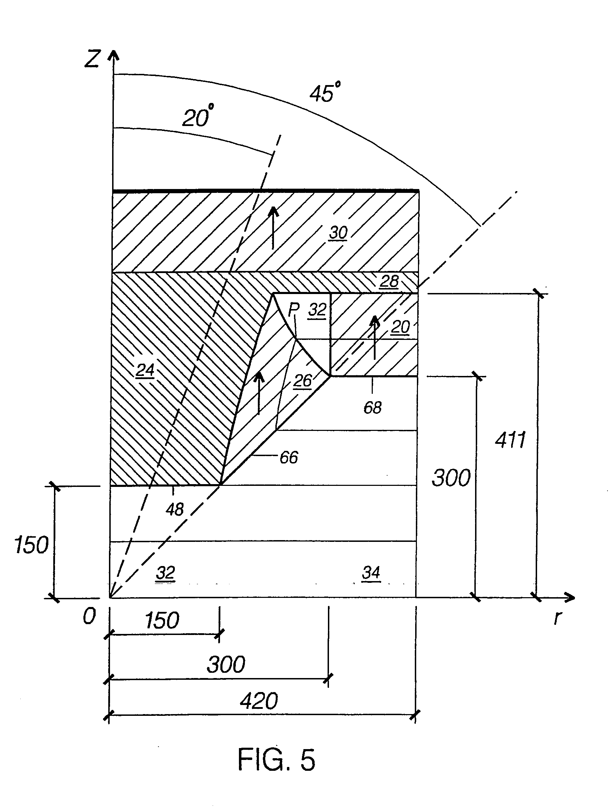

Fig. 5 illustrates the same structure with some typical dimensions in cm of the upper right quadrant to which the invention should not be limited. The angles 45° and 20° correspond to the half-angle $\theta_0$ and half-angle $\theta_1$ . The space underneath the structure and thus between it and the corresponding not-shown structure beneath forms the cavity for receiving the patient. As will be noted, the cavity includes a smaller region 32 for accommodating the head of the patient, and a larger contiguous adjacent region 34 for accommodating the larger shoulders of the patient.

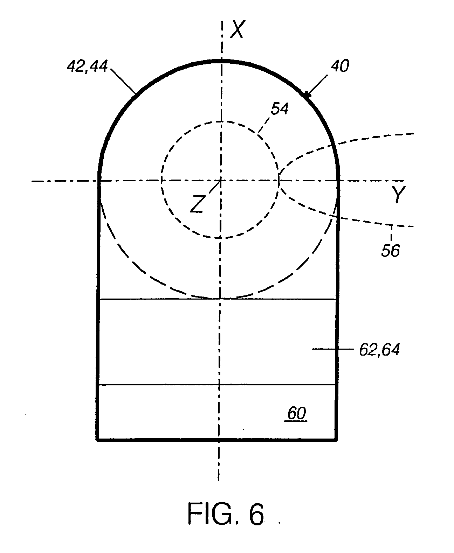

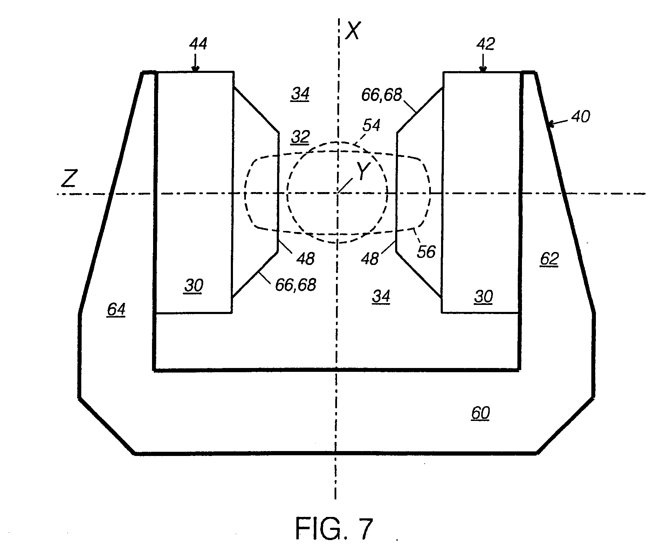

Figs. 6 and 7 show, respectively, top and side views of a complete form of a preferred embodiment according to the invention indicated by 40. Looking first at Fig. 7, imagine that the structure illustrated in Fig. 5, rotated about the vertical and horizontal axes originating at the origin 0, are thus expanded to include both upper right (shown in Fig. 5) and left quadrants, to form a circular-symmetrical magnetic structure 42, spaced opposite to an identical structure 44 corresponding to the lower right and left quadrants. The cavity space between referenced 32 which is bounded by the bottom surfaces 48 of the inner ferromagnetic cores 24 (see Fig. 5) is the head cavity bordered on all sides by the larger shoulder cavity 34 bordered by the inner surfaces 66, 68 of the permanent magnetic components 26, 20. The head 54 and shoulders 56 of a patient lying on his or her back is illustrated by the dashed outline and extends parallel to the y-axis. The shoulders are behind the plane of the drawing. To the opposed symmetrical structures made up of the rotated quadrant illustrated in Fig. 5 has been added a conventional soft ferromagnetic U-shaped yoke with its bight 60 at the bottom and the two arms 62, 64 embracing the corresponding backs of the added cylindrical magnets 30. The z-axis in Fig. 6 is at the center perpendicular to the plane of the drawing, forming with the vertical x-axis and horizontal y-axis a rectangular coordinate system. The top view of Fig. 6 shows the circular symmetry about the z-axis of the main magnetic components 42, 44. In this and several of the other embodiments, the magnetized conical sections from opposite sides taper toward the origin, represented by the y axis in Fig. 7, so that the narrow end of the cone, corresponding to the point $P_0$, is adjacent to the head cavity 32 and the wider cone end represented by higher values of z (Fig. 4) is further remote from the head cavity. Fig. 9 is a perspective view of the structure of Fig. 7, and Fig. 8 is an exploded view. For simplicity, the additional cylindrical magnets 30 at the top and bottom have been omitted, but they have the same lateral extent as the adjacent lateral extension 28 of the high permeability core 24. The Fig. 8 view is depicted as if the whole structure 40 was lifted out of the yoke bight 60 and then exploded. The Fig. 9 embodiment shows one quadrant corresponding to Fig. 5 cut out and removed to show the inner construction. As will be observed, with the structure 40 lying on its base represented by the yoke bight 60, due to the symmetry, the patient can be introduced into the cavity from both sides as well as from the top, as the shoulder cavity 34 surrounds the smaller head cavity 32. The patient is positioned for head NMR imaging with its head inside the cavity 32 and its shoulders extending into the cavity 34. The object is to produce a magnet configuration that will generate a substantially uniform imaging field in a region of interest surrounding the patient's head 54, the magnetic field having an intensity $H_0$ ($H_e$ in the Appendix) along the z axis in Fig. 7.

The intensity $H_0$ is related to the remanence J of the conical magnetic material by the equation:

$$K = (\mu_0 H_0)/J ,$$

where $\mu_0$ is the magnetic permeability of a vacuum and K is a design parameter which is a function of the dimensions z of the structure as shown in the Appendix.

The dimensions in millimeters shown in Fig. 5, which are otherwise to scale, are only exemplary, and indicate representative values for one magnet design for a value of K = 0.426, which would correspond to a uniform field in the imaging region of:

$$(\mu_0 He) \sim 0.55 \text{ Tesla, for } J \sim 1.3 \text{ Tesla.}$$

In the implementation illustrated in Figs. 6-9, the magnetic structure is open from all sides except for the yoke base side to allow access to the surgical area. This opening usually introduces a distortion of the uniform field in the imaging region that must be partially corrected to bring the field variation within acceptable limits, typically within 10 ppm. This correction is part of the tuning or shimming of the magnet that compensates the distortion induced not only by the opening but also by the magnetization and fabrication tolerances.

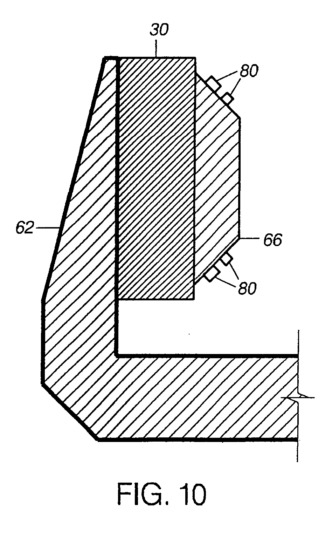

One way to accomplish the tuning of the magnet is by means of a filter structure assembled on the inner magnetic structure surfaces 48, 66, 68 as described in detail in one of my publications entitled "Linear Theory of Pole Piece Design in Permanent Magnets", published in the Proceedings of the Thirteenth International Workshop on Rare Earth Magnets and their Applications, Sept. 11-14, 1994, Birmingham, United Kingdom, whose contents are incorporated by reference in this application. This paper explains that the design of a suitable filter structure is the result of a linear theory of pole pieces developed by the author, in which the imaging region is assumed to be confined in a cylinder whose axis contains the imaging center and is perpendicular to the pole pieces. The cylinder is closed by the surfaces of the two pole pieces that act like reference surfaces of the magnetostatic potential. This potential generated by the magnet inside the cylinder is expanded in cylindrical harmonics as shown by equation 22 in the referenced paper in which the symbols have the meanings indicated in the paper and therefore do not need repeating here. In that equation, the first term on the right hand side is the uniform field, and the other terms are the harmonics of the field distortion corrected by the filter structure as described in that paper. These harmonics are eliminated if the sections of the filter are polarized with a dipole moment that satisfies equation 24 of the paper. As will be observed from the paper, the series of the field distortion converges rapidly and, as a consequence, only the lower order harmonics have to be compensated. The system of Figs. 6-9 can be compensated by concentrating on the inner surfaces 48, 66, 68 of the structure bounding the cavities 32, 34 a suitable distribution of correcting dipole moments in magnets. Specific examples of filter design suitable for this application can be found in the paper and in my issued patents Nos. 5,475,355 and 5,495,222, whose contents are incorporated by reference in this application. One form of active filter structures are thin sandwiches of outer soft ferromagnetic plates bounding the cavity, magnetically isolated from the supporting magnetic structure, with a permanent magnetic insert or inserts between the plates. They can be located in accordance with the principles enunciated in the paper along the cavity-bounding interior surfaces to reduce or minimize field distortion. The filter structures typically tend to be positioned in the vicinity of the region of interest, which typically embraces the head cavity. Fig. 10 illustrates schematically one possible filter structure 80 on the conical surfaces of the structure, shown as several discrete or annular members made up of ferromagnetic and magnetized material which have the necessary magnetic properties and are distributed such as to compensate for field distortions as described in the referenced paper and patents.

The region of interest would typically be a spherical region or a region approximating a spherical region within the cavity, centered (for example, at z = 0, y = 0) where the geometry is symmetrical at a position where the degree of uniformity is acceptable, as explained typically a uniformity that does not vary by more than about the 10 ppm over the whole of the region of interest.

Those skilled in the art will appreciate that the invention is not necessarily limited to structures with the dimensions indicated in the drawings, which are only to illustrate the size of a particular embodiment. The preferred geometry illustrated can be replaced by other geometries following the principles described herein. In particular, the half-angle $\theta_0$ and half-angle $\theta_1$ are not limited to the two values given in the preferred embodiment. Those values are preferred because they represent a good practical compromise among factors such as the overall size of the unit, the volume of magnetic material required, the magnetic field intensity, and the patients accommodation. For example, increasing $\theta_0$ (for example, $\theta_1 = 20°$, $\theta_0 = 50°$, for K = 0.55) increases the structure's size, requires more magnetic material, and may undesirably reduce the patient's cavity, though it will also allow a higher field intensity ($\mu_0$ He) ~ 0.71 Tesla with the increased magnetic material. Keeping $\theta_0$ at 50°, but increasing $\theta_1$ to 30°, for example, likewise may also require more magnetic material but with a K = 0.36 will result in a smaller field intensity ($\mu_0$ He) ~ 0.47 Tesla. Reducing both angles will likely produce too narrow a practical structure with inadequate patient space. These other geometries are also considered within the scope of the invention. It will also be understood that the patient may be rotated about the y axis within the magnetic structure in order to allow the surgeon to access different sides of the brain.

A number of important advantages flow from the configurations of the invention, which include: an overall smaller structure size requiring less magnetic material while maintaining a high field intensity, accomplished with a structure that is considerably simpler than alternative structures.

To reduce dimensions and weight (very important when the structure is to be used in a surgical suite), the space between the body and the magnetic structure should be reduced to a minimum compatible with the design requirements of the structure bearing in mind the stringent requirements of field uniformity in the imaging region. Due to the close proximity of brain and shoulders the field uniformity must extend to the neck and shoulder region, though the field uniformity need not be quite as stringent in the neck and shoulder region.

Those skilled in the art will also appreciate that the invention is not limited to the specific shape of the yoke, and other geometries are also considered within the scope of the invention so long as saturation is avoided.

The description following applies to a new embodiment that includes improvements over that described earlier.

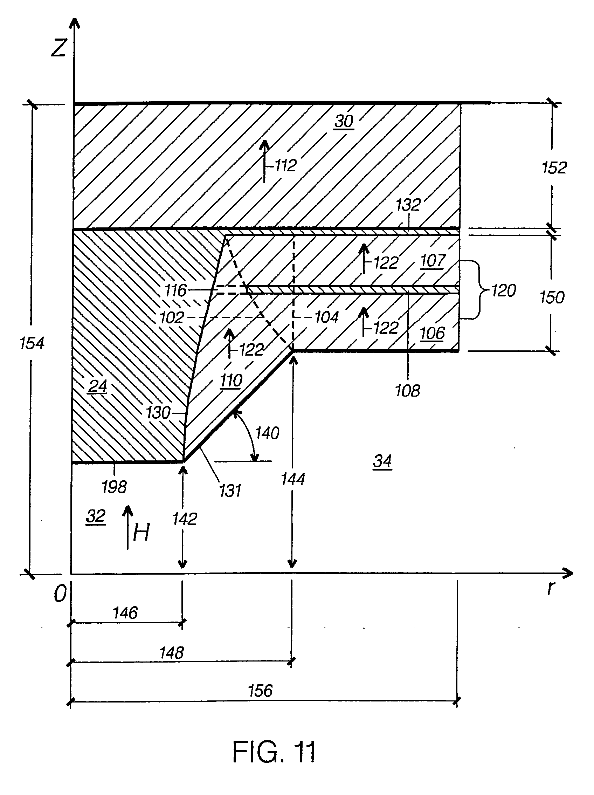

Fig. 11 is a cross-sectional view similar to that of Fig. 4 of one form of improved magnetic structure for NMR imaging of the head. For purposes of clarification, to show more clearly how the improvement relates to the previous embodiment, several dashed lines 102 and 104 have been added to Fig. 11. Dashed line 102 corresponds to the curved concave line AB of Fig. 4 that represents the far annular surface of the conical magnet 26, remote from the apex represented by point $P_0$, and that separates that annular surface from the adjacent non-magnetic space 32 shown empty in Fig. 4. Dashed line 104 corresponds to the vertical straight line AC of Fig. 4 that represents the inner annular surface of the first or inner cylindrical magnet 20 (Fig. 4) and that also bounds the opposite side of the non-magnetic space 32. The latter is the non-magnetic element 32 with the triangular cross-section referred to earlier in which the field direction is anti-parallel to that within the cavities.

A principal feature of the improvement of the present embodiment is to reconfigure the permanent magnetic structure in order to improve the field uniformity within the head and shoulder cavities. This is accomplished in accordance with a feature of the invention by extending laterally inwardly the inner cylindrical magnet (referred to as 120 in Fig. 11) substantially to fill or greatly reduce that non-magnetic region (32 in Fig. 4) with magnetic material having the same direction of remanence 122 as that of the outwardly-extending inner cylindrical magnet 120 up until the imaginary dashed line 102. Put another way, the far surface of the conical magnet 110 is extended upwardly and outwardly to meet the adjacent inner cylindrical magnet 120. Since the latter is no longer completely cylindrical as now the dividing line between the conical magnet and the inner cylindrical magnet 120 has become blurred or unclear, the description here and in the claims refers from time to time to an "essentially cylindrical magnet", meaning that the structure 120 still behaves mainly as if it were a simple cylindrical magnet and can be so treated in the design analysis. The resultant configuration corresponds to that disclosed in Fig. 3.1 of Appendix A.

These kinds of magnetic structures employing conical and cylindrical magnets and designed to produce a uniform field in a region of interest capable of providing NMR imaging provide best results when the remanences of the conical 110 and cylindrical magnets 120 are oriented in the same direction, parallel to the longitudinal axis Z of the structure. However, this may introduce distortions in the uniform field due so-to speak to the non-matching magnetic interface between the adjacent surfaces of the conical magnet and the inner cylindrical magnet (designated schematically by dashed lines 102 and 104). The invention of this improved structure also deals with several preferred embodiments which allow closer coupling of the adjacent surfaces of the conical magnet and the inner cylindrical magnet without significantly impairing the field uniformity and in some cases actually improving the field uniformity.

One possible solution according to the present invention is to replace the triangular non-magnetic region 32 of Fig. 4 with magnetic material having a value of remanence approximately twice that of the conical magnet 26 of Fig. 4 and having the same orientation. This is less preferred because it reduces the active field. The reason is that, if the choice of material for the replaced triangular 32 section is chosen to provide the greatest remanence, it means that the remanence of the conical section will be much lower, resulting in the smaller field intensity.

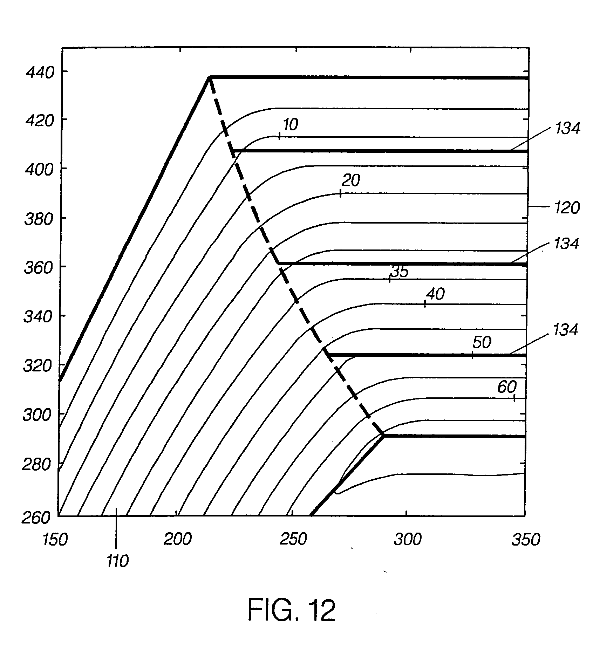

A preferred embodiment is for the inner cylindrical magnet 120 to maintain the higher value of remanence, the same as that of the conical section, but preferably is divided horizontally into at least two segments 106 and 107 separated by a magnetic strap 108, which, as described earlier, is a thin high permeability layer, only thick enough to prevent saturation, that forces the facing contacted surfaces of the inner cylindrical magnet segments 106, 107 to follow equipotential lines or surfaces. Note that the strap 108 terminates at the imaginary curved line 102, still leaving a small non-magnetic region 116 separating the inner strap end from the inner conical surface 130. This is the preferred structure depicted in Fig. 11. Otherwise, the curved line extending between $P_0$ and $P_2$ in Fig. 4 is essentially similar to the same curved line 130 in Fig. 11, and the curved line AB in Fig. 4 is essentially similar to the curved dashed line 102 in Fig. 11. The thin laterally extending ferromagnetic strip 132 in Fig. 11 corresponds to that designated 28 in Fig. 4 and functions as a magnetic strap. Another way of viewing this embodiment compared to that of Fig. 4 is as a virtual integration of the conical magnet 110 and the inner cylindrical magnet 120 to form nearly a single structure with the same vertical remanence 122, orientation as well as magnitude, leaving still a smaller non-magnetic region 116 and for best results requiring at least one strap 108 preferably located midway inside the inner cylindrical magnet 120. Nevertheless, the overall result is for improved field uniformity in the region of interest, which as before is generally a sphere whose center is at the origin O within the smaller cavity 32. As a further alternative, several evenly spaced parallel magnetic straps 134 can also be employed as illustrated schematically in Fig. 12. Not shown in Fig. 12 are the small non-magnetic sections that preferably separate the ends of the straps from the inner surface of the conical magnet. Fig. 12 also shows some of the equipotential lines in such a structure. The abscissa and ordinate in Fig. 12 are in cm. The thicker line at the top of Fig. 11 symbolically represents the yoke shown more clearly in Fig. 7.

It will also be observed that the inner conical surface, 130 in Fig. 11, is not a perfectly straight line. Nevertheless, for present purposes, it can properly be described as a surface of a conical structure and will behave essentially the same as if it were perfectly straight.

The overall configuration of the Fig. 11 embodiment, including its conical angle 140 formed as shown between the outer conical surface 131 and a plane perpendicular to the z direction, its cavity dimensions 142, 144, 146, 148, the height 150, 152, and the overall height 154 and width of the quarter section illustrated in Fig. 11, can be similar to that given in Fig. 5. Some dimensions will vary to achieve best operation, as is common with these designs. Following the principles enunciated in the Appendix will enable the person of ordinary skill in the art to devise a structure adequate for his or her intended purpose. The strap dimensions are kept as thin as possible to avoid saturation. A thickness of 10 cm should prove adequate for most purposes.

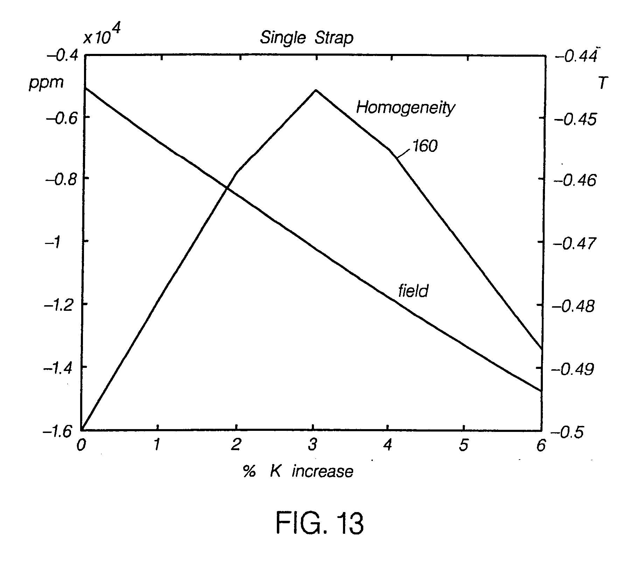

As explained in Appendix A, when a series of computation are conducted of the field intensity in the region of interest and its variation over the region of interest for different values of K, it was unexpectedly discovered that a small adjustment in K can result in an improvement of uniformity, illustrated in Fig. 13 for the embodiment of Fig. 11 with a single strap. When the variation in field intensity in ppm is plotted against the values of K, a curve 160 results that peaks at a slightly increased value of K. The value of the field in Tesla, shown by the line labeled "field" for that value of K, is not significantly less than that for the nominal value. Best results are achieved at a K value increased by about 3%. The number may be somewhat different for other nominal K values but, interestingly, is typically higher by a few percent.

A feature of the invention is a design method which takes advantage of this phenomenon. Normally, a nominal value of K is chosen determined by the magnetic materials that will be used and the field intensity wanted in the region of interest. For example, where $J_0$ is chosen equal to approximately 1.3 T, and the nominal value of K chosen is about 0.49, then $\mu_0 H_0 = 0.64$ T. The next step is to perform a series of computations measuring the field uniformity and field intensity as K is varied over, say, a range of 1.-1.6. A graph similar to that of Fig. 13 should result, and the designer can then chose that increased value of K that provides the desired uniformity and field strength. Generally this will be a value of K several percent higher than the nominal value. To implement this design feature requires a small reconfiguration of the magnetic structure. For example, K can be increased by increasing H, obtained by increasing the amount of magnetic material present in the structure, such as by increasing the thickness of the cylindrical magnet 30. In addition, a magnetic material from the same family but with larger remanence can be chosen to maintain the same field intensity H. Since the increase wanted of K is small, only a small change in the configuration is necessary to obtain the benefits of this aspect of the invention. Other ways of increasing K will be evident to those skilled in this art.

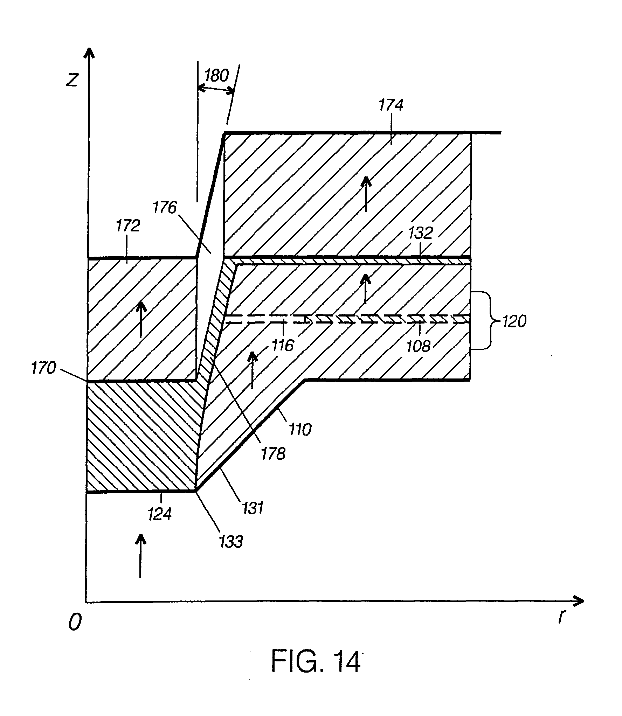

A modification of the external magnet may be adopted in the design of the structure of the invention in accordance with another feature of the invention, for the purpose of reducing the weight of the magnet, as shown in Fig. 14. The hollow geometry of the inner ferromagnetic pole piece 124 is recessed 170 to receive and house part 172 of the magnetized material of the outer cylindrical magnet which extends over the center as shown, the remaining part being designated 174 and being separated by a non-magnetic region 176 having a trapezoidal-cross-section. The thickness in the Z direction of the two cylindrical parts 172, 174 of the outer cylindrical magnet can be about the same as that in the Fig. 11 embodiment. The angled extension 178 joining the pole piece 124 with the strap 132 functions similarly to a strap. The thickness of the reduced pole piece can be determined by design or by trial and error. The angle indicated by 180 will typically be close to that of the inner conical surface of the conical section 110. The result is that part of the space previously occupied by the ferromagnetic pole piece is now occupied by the external magnet. Hence, overall, the size and weight of the structure is reduced. This can be of great importance, since these structures intended for human use are very large and, since magnetic material is intrinsically heavy, the entire structure can weigh several tons. Structural variations that reduce size and weight can be important for certain applications. However, the field in the region of the external magnet becomes more non-uniform thereby reducing the efficiency of transfer of the energy stored in the external magnet into the energy of the magnetic field generated by the magnet. Hence, one can expect that with the saving of some weight of the ferromagnetic component of the magnet there will result a reduction of the field strength in the region of interest.

I described above the uniform field distortion problems arising from the finite dimensions of a practical magnet and by the fabrication tolerances of the geometry and distribution of the magnetization. The distortion due to the effect of finite dimensions can be at least partially compensated in the design phase by modifying the value of K of the external magnetic structure as described above, but the distortion due to fabrication tolerances cannot be compensated in the design phase and requires another approach. Several of my earlier patents have proposed compensation schemes for different magnetic structure geometries involving the judicious placement of magnetic dipoles about the structure. For example, USP 5,055, 812 describes compensation means for a yokeless permanent magnetic structure; USP 5,428,333 also describes different compensation means for a yokeless permanent magnetic structure. Those compensation schemes however may not be best suited for the conical geometry that characterizes the present invention.

In accordance with another feature of the invention, a better compensation scheme for the conical magnetic structure geometries described herein comprises the judicious placement of magnetic dipoles about the structure based on principles different from the principles used in the referenced patents. As described in more detail in Section 4 of Appendix A, the compensation shimming is performed by means of a distribution of magnetic dipoles on the outer conical surface 131. Preferably, the magnetic dipoles are in the form of axially-spaced discrete shimming rings or annular elements. The location of the magnetic dipoles, and their magnitude and orientation are determined by following the methodology described in great detail in the Appendix. Briefly, the shimming method of the invention requires the following steps:

1. Assemble the entire conical magnetic structure as described above. Preferably, but not necessarily, the magnetic structure is designed to incorporate the adjustment in K to compensate for the effect of finite dimensions.

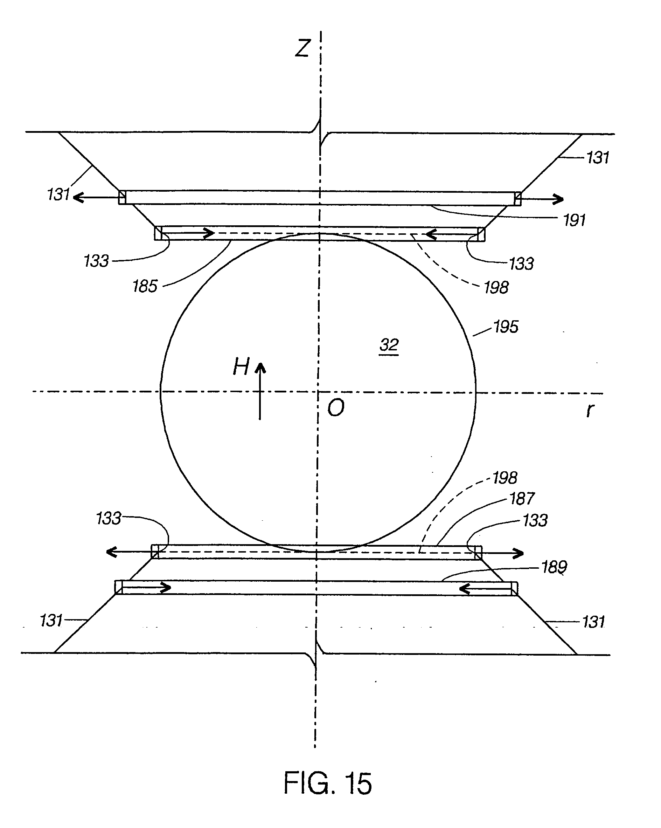

2. Measure the magnetic field uniformity over a reference sphere 195 (Fig. 15) having an origin at the structure center and preferably reaches to the bottom of the opposed center elements whose surfaces 198 bound the cavity 32 and includes the region of interest. This measurement essentially maps the field intensity over the reference spherical surface. Non-uniformities representing distortions of the desired uniformity will typically be present.

3. Choose the number of compensation rings to be employed. The number typically will be at least two or three. The rings of permanent magnetic material are dimensioned to surround and contact the conical surfaces 131. The rings, if more than one, lie in parallel planes and are axially spaced, i.e., in the z direction, and thus will necessarily have different radii. The plane of the rings, preferably, is perpendicular to the z axis. If more than two rings are chosen, then their axial spacing is preferably equal. The effect of the rings depends on their closeness to the region of interest. Thus, preferably a first ring is placed on the outer conical surface 131 at its bottom vertex 133 with its lowermost surface nearly coincident with the cavity-bounding surfaces 198. If a second ring is used, it preferably is placed a short distance above or below the first ring on the outer conical surface. The ring axial spacing is not critical except they should be located close to the region of interest. Their magnetization is determined as will be explained below.

4. Magnetize the rings such that when positioned on the conical magnet, the orientation of their remanence is radial and perpendicular to the z axis, i.e., parallel to the r axis in the figures. It is understood that pairs of rings are preferably used so that a ring on the upper conical section is matched by a ring on the lower conical section and arranged symmetrically to one another. The rings are preferably always magnetized in anti-parallel relationship such that when the first or lowermost ring on the upper cone is magnetized radially inwardly (shown by the horizontal arrows), its counterpart on the opposite cone (lower cone in the figures) is magnetized radially outwardly, and the next or second ring on the upper cone is also magnetized radially outwardly, and so on. Thus, an inverted magnetization relationship is maintained among the rings.

5. The configuration of the rings, i.e., their magnetizations and orientations, are determined by computing the system of equations defined by equations 4.12 and 4.13 of Appendix A, whose terms are defined by the previous equations 4.1-4.11, using the field mapping obtained in step 2, i.e., without the rings present.

6. Place the first ring on the outer conical surface 131 at its preferred location at the bottom vertex 133 and if used the other rings as described.

7. Re-measure the magnetic field uniformity over the same reference sphere having an origin at the structure center and co-spherical with the region of interest. Typically, a relatively coarse compensation will result from the presence of the compensating rings.

8. Re-compute the system of equations defined by equations 4.12 and 13 of the Appendix, whose terms are defined by the previous equations 4.1-4.11, using the new field mapping obtained in step 7 with the rings present.

9. Reconfigure the ring or rings in accordance with the new computations obtained in step 8 compared with that obtained in step 5 to adjust the dipole distribution to reduce the distortion and reassemble. When the uniformity is now re-measured with the reconfigured rings in place, typically, an improved compensation will result, and the process can be repeated until the desired value of uniformity is achieved.

Reconfiguring the rings to improve uniformity can be done in several ways:

a) re-construct and magnetize the first and any other rings present using a material of greater or lesser remanence to increase or decrease the magnetization and reassemble and re-measure to determine whether the effect is better or worse;

b) add a second or third or more rings, and re-measure to determine whether the effect is better or worse. In general, the more rings used, the greater the field uniformity but at the expense of a small reduction in field intensity. Further adjustments can be obtained by repositioning either or both of the rings, or increasing or decreasing the radial or vertical thickness of the rings. However, they should preferably always remain vertically spaced from one another.

The dimensions of the ring or rings are not critical. Typical radial and vertical thicknesses can vary between about 1-5 cm. It will be observed that when more than one ring is employed, then they will necessarily have different inside and outside radiuses. In all cases, the planes of the rings are perpendicular to the cone axis and parallel to the bottom surface of the inner ferromagnetic core.

Summarizing, in general, shimming rings will preferably be placed on both the upper and lower conical sections at corresponding locations, and the orientation of magnetization of the rings at their corresponding locations will be chosen to be anti-parallel. More particularly, in the preferred embodiment of Fig. 15, the first ring 185 located at the bottom of the outer conical surface of the upper cone is magnetized radially inwardly, that is, the N pole faces inwardly and the S pole faces outwardly. Conversely, the corresponding first ring 187 located at the bottom of the outer conical surface of the lower cone is magnetized radially outwardly. In this context, "bottom" means the surface bounding the cavity 32. Preferably, also, plural rings on a cone are magnetized anti-parallel. Thus in Fig. 15, on the lower cone, the first ring 187 is magnetized outwardly, and the second ring 189 is magnetized inwardly, also in anti-parallel relationship with the corresponding second ring 191 on the upper cone.

As explained in greater detail in Appendix A, in Figs. 4.1 and 4.2, the line $P_0$-B follows the outer cone surface, and the reference sphere is shown in the first quadrant with a radius of $\rho_i$. Fig. 4.4 shows the effect of the ring locations, with the parameter 0 representing a ring at the narrow end of the cone, in the lowermost position, and the parameter 1.0 representing a ring at the wider end of the cone, in the uppermost position furthest from the origin. Note that as the ring location moves further from the origin its effect lessens. Fig. 4.6 shows the reduced distortion of the redesign with the slightly increased value of K. Fig. 4.7 illustrates a partial or coarse compensation obtained using the two-ring example illustrated in Fig. 15. The inverted S-curves show the field effect of the two rings at $\theta = 0°$, and the two horizontal curves illustrate the field uniformity by field mapping over the sphere in the first quadrant for this simple illustrative example for the rings. The lower curve shows the distortion without the rings present, and the upper curve shows the effect of the rings. It will be noted that there is a rough compensating effect when the two curves are combined. To improve the uniformity, it will be necessary for this simple example to add more rings to achieve the high value of uniformity desired for optimum MRI imaging.

As with the other embodiments, it will be appreciated that the embodiments of Figs. 11 and 14 represent only one quadrant of the structure. The full structure is obtained as illustrated in Figs. 7-9 by rotating that quadrant about the vertical and horizontal axes originating at the origin 0, and thus expanded to include both upper right (shown in Fig. 11) and left quadrants, to form a circular-symmetrical magnetic structure 42, spaced opposite to an identical structure 44 corresponding to the lower right and left quadrants.

In accordance with still further improved embodiments of the invention, it was discovered that, by a careful configuration of the annular surface of contact between the inner surface of the conical magnetic section and the outer surface of the high permeability magnetic material, as explained below, it is possible to integrate the different sections of a permanent magnetic section into a single permanent magnetic section which greatly simplifies the construction and fabrication of the overall magnetic structure compared with the embodiments illustrated above.

Refer for the moment back to Fig. 1, which shows the basic conical structure 10 of magnetic material contained between two coaxial cones of half angles $\theta_1$ and $\theta_0$. The material is magnetized 16 with a uniform remanance $J_0$ parallel to the axis z ( the longitudinal axis 14 ) of the cone. The medium surrounding the external cone is non-magnetic, and the internal cone 12 is the surface of a ferromagnetic cone of infinite magnetic permeability. Assume now a system of spherical coordinates $\rho$, $\theta$, $\psi$. In the limit of infinite radial dimensions, the magnetostatic potential $\Phi$ generated by remanence $J_0$ within the magnetic material as described earlier is as defined in equation 2.3 in Appendix B, where

$u = \cos\theta$, $u_0 = \cos\theta_0$, $u_1 = \cos\theta_1$, and $\mu_0$ is the magnetic permeability of a vacuum.

The magnetostatic potential is the potential of a uniform field of intensity Ho oriented parallel to the z axis and magnitude: $\mu_0 H_0 = KJ_0$ where K = the value calculated in equation 2.7 of Appendix B.

The surface designated 8 is the outer surface of the magnetized conical section, and the surface designated 5 is the inner surface of that conical section.

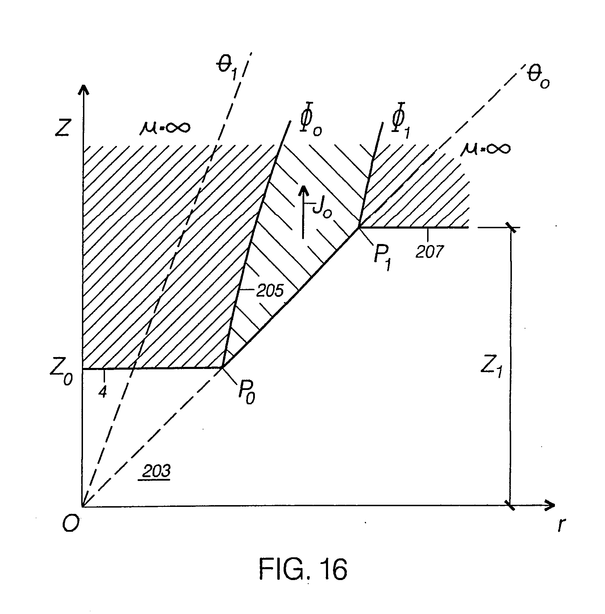

The basic schematic of Fig. 1 can be transformed into the structure of Fig. 16 where the magnetized material in the region $-z_0 < z < +z_0$ is replaced by a non-magnetic material 203 (the gap) confined between two circular surfaces 4 of infinite magnetic permeability. The equipotential surfaces 205 emerging from the circular boundaries also become surfaces of infinite magnetic permeability.

Also as shown in Fig. 16, the equipotential surfaces 207 that contain the planes $z = \pm z1$ can be transformed into surfaces of infinite magnetic permeability. The transformation defined in Fig. 16 does not affect the field generated by the original conical structure. Thus, Fig. 16 generates the central gap 203 needed for imaging and enlarges the z dimension of the magnet necessary to accept the rest of the body.

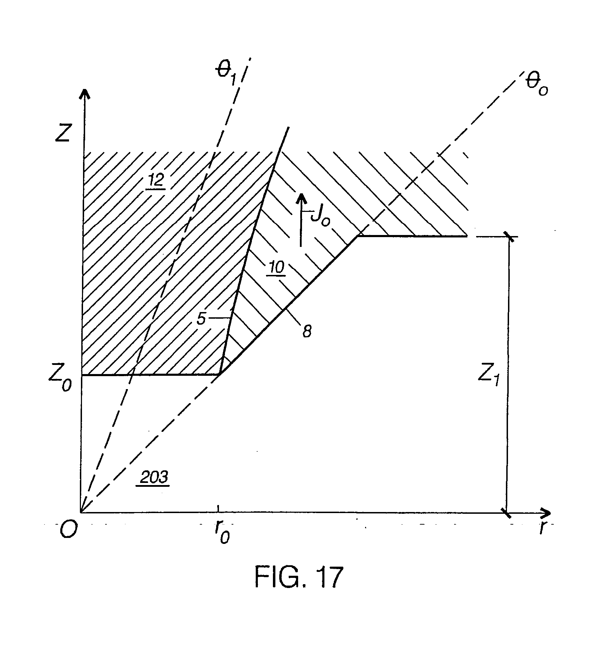

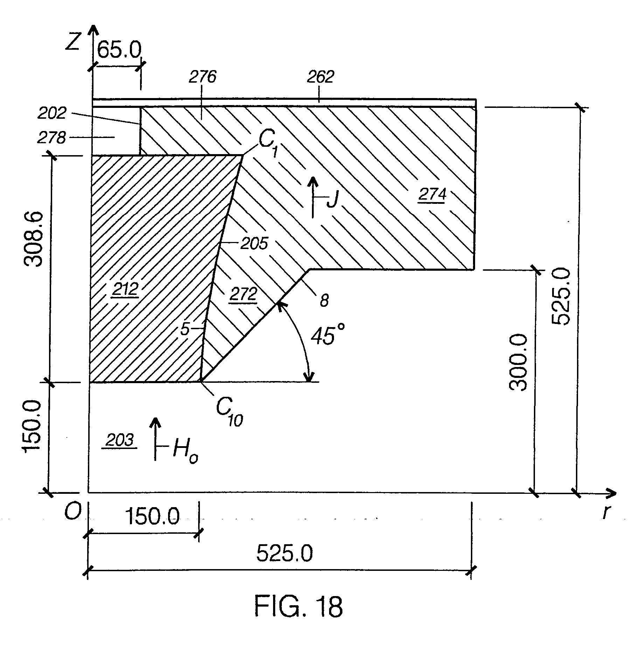

A simplified version of the structure of Fig. 16 is shown in Fig. 17 where the exact transformation of the $\mu = \infty$ material at $z = \pm z_1$ is replaced by the same magnetized material of the cone with the uniform remanence $J_0$ parallel to the axis z. The simplified version takes advantage of the distance of the transition at $z = \pm z_1$ from the imaging region in the gap 203. The example of Fig. 18 of the simplified schematic of Fig. 17 corresponds to magnet dimensions in mm that maintain the perturbation of the uniform field within the gap between the pole pieces well within the limit of correction with standard shimming techniques. The basic dimensions of the magnet components shown in Fig 18 correspond to a selection of the cone angles $\theta_1 = 20°$, $\theta_0 = 45°$. The double line 262 at the top of Fig. 2.4 represents the magnet yoke that closes the flux of the magnetic induction. Ideally, the imaging region can be assumed to be a sphere of radius $z_0$ centered at the center of the gap 203 between the pole pieces 212.

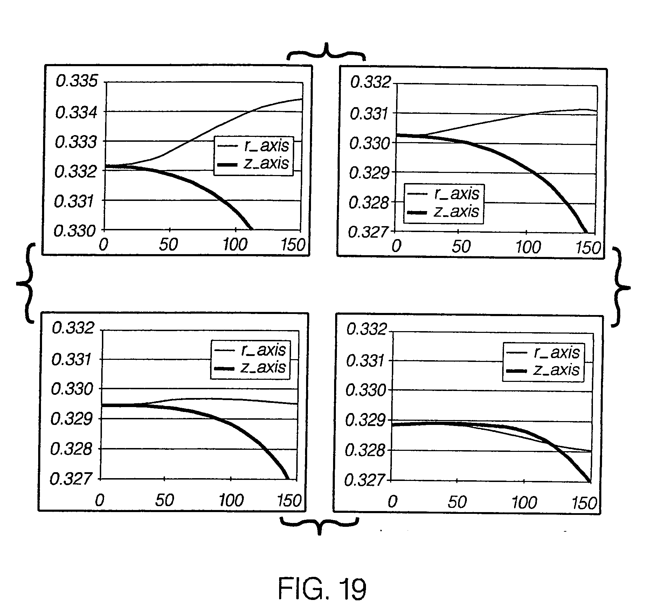

Fig. 19 shows the plotting of the field along the axis z and the radial coordinate r in the equatorial plane resulting from approximating the exact equipotential surface 205 of the pole pieces given by equation 2.3 with an increasing number N of segments. Where N = 1 (upper left graph), meaning the calculation is carried out on a straight line between C1 and C10 in Fig. 18, the uniformity in the gap is relatively poor. As the number of segments calculated over the length of the surface represented by the line C1-C10 increases signified by increasing values of N (upper right graph, N=2; lower left graph, N=4), the field uniformity improves. The slightly concave curved line C1-C10 that appears in Fig. 18 corresponds to the calculations performed with N = 9 segments (lower right graph). The actual coordinates for that particular embodiment are listed below in the TABLE for the dimensions indicated in Fig. 18. The plots in Fig. 19 show the benefits of implementing the exact profile in the manufacture of the magnet.

The example of Fig, 18 further shows that a field of 0.45 Tesla is attained in the gap 203 between the pole pieces 212 with about 2.9 tons of rare-earth magnetic material of remanences = 1.38 Tesla. Thus, this improved magnetic structure provides an efficient and powerful imaging tool for clinical as well as interventional applications.

The TABLE following below represents the coordinates of 10 points along the surface represented by the line C1-C10 in Fig. 18 defining 9 line segments. With the assumed dimensions indicated in Fig. 18, and the assumed angles given above, which is exemplary only, a conical magnetic section 172 is configured that will maintain the distortions of the desired uniform field in the gap at sufficiently small values that allows correction by standard shimming techniques.

It will be understood that the values given in the TABLE that determine the shape of the boundary represent just one example of a suitable configuration. As a person of ordinary skill in this art will understand, choosing other initial dimensions for the cavity and other angles and another magnetic material, as also explained above, will require the re-calculation of the configuration of the boundary surface represented by the line C1-C10 in the first quadrant to obtain the improved uniformity.

One example of one method for calculating the configuration of the boundary surface 5 is as follows, though it will be understood that the invention is not necessarily limited to this preferred method.

1. One possible suitable starting point is a choice of the head and shoulder cavity dimensions that will accommodate the head and shoulders of an ordinary adult. In the example given, the head cavity has a radial dimension of 300 mm (remember that only one quadrant is shown in Fig. 18) and a height, the vertical spacing between the pole pieces, also of 300 mm.

2. Suitable angles are chosen to accommodate the shoulders of the patient and not extend unnecessarily the overall dimensions of the structure which are the example angles given above.

3. The strongest permanent magnetic material is preferably used which determines its remanence J which with a typical value of K determines the desired uniform field intensity $H_0$ in the head cavity or gap 203.

4. Thus the coordinates of the point C10 and the value of the magnetostatic potential $\Phi$ are determined by the previous choices made.

5. The magnetostatic potential $\Phi$ is maintained constant along the whole boundary surface represented by the line C1-C10.

6. The coordinates for the remaining nine points (or for whatever number of segments is chosen) of the boundary surface are calculated from Equation 2.3 of Appendix B for $\Phi = C_0$ and in this way the r and z coordinates are determined for each of the remaining equidistant points C9-C1, along the line resulting in the profile of the surface represented by the line C1-C10 that will produce a desired equipotential surface.

7. A similar process is carried out to determine the location of the boundary 202 between the inner surface of the upper permanent magnetic section 276 and the adjacent non-magnetic region 278, which can be, for example, air, since again the determining factor is the magnetostatic potential that is maintained constant to minimize field distortions in the region of interest. In this way, for the example given, the boundary is located about 65 mm from the z axis. The effect on the field of choosing other values for the height and width of the non-magnetic region 278 is indicated in Appendix B and by the values given in Table I of Appendix B.

TABLE

| $C1_r$ | 205.80 | C1z | 458.60 |
|---|---|---|---|
| $C2_r$ | 197.78 | C2z | 427.15 |
| $C3_r$ | 190.38 | C3z | 395.08 |
| $C4_r$ | 182.37 | C4z | 363.63 |
| $C5_r$ | 175.58 | C5z | 331.56 |
| $C6_r$ | 168.18 | C6z | 300.11 |
| $C7_r$ | 162.63 | C7z | 267.42 |
| $C8_r$ | 157.08 | C8z | 237.82 |
| $C9_r$ | 152.76 | C9z | 202.67 |
| $C10_r$ | 150.00 | C10z | 150.00 |

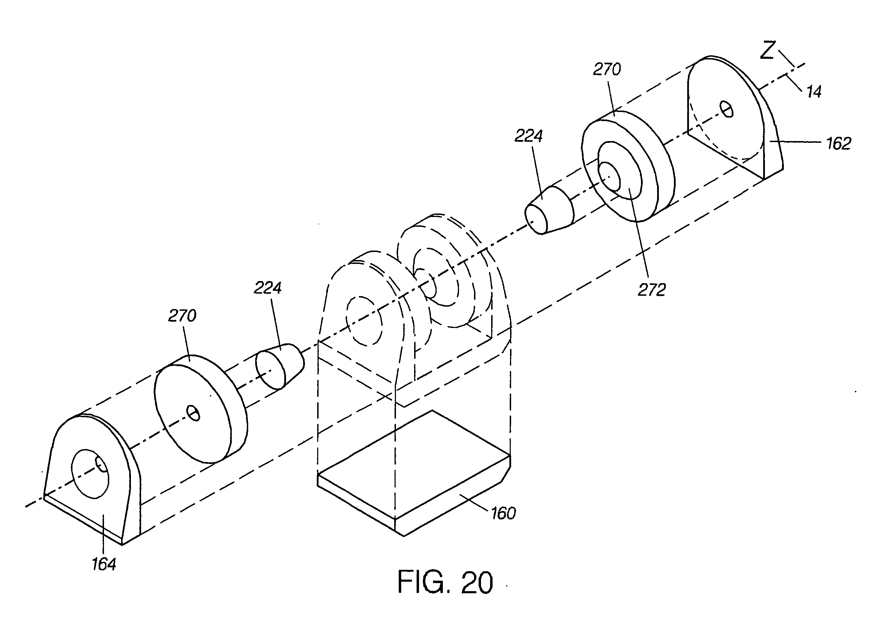

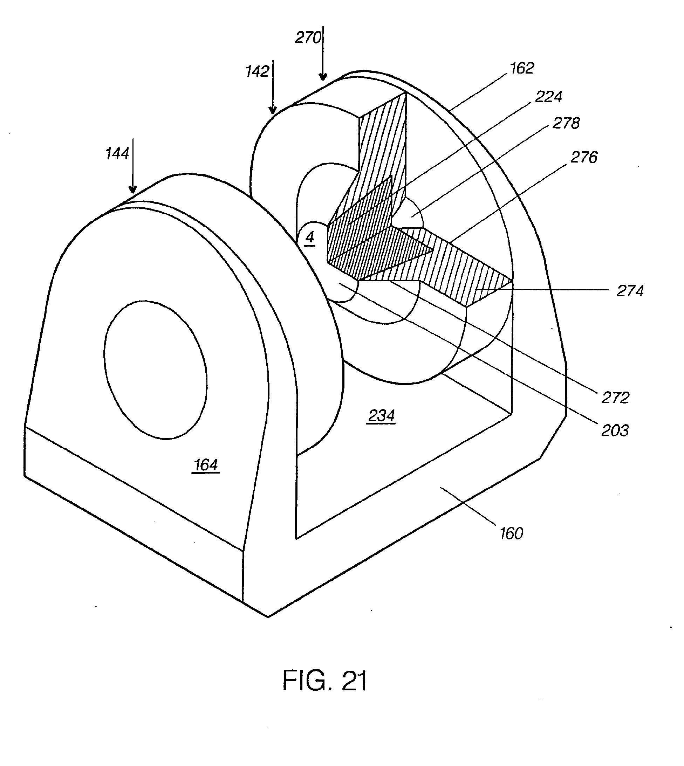

Fig. 21 is a perspective view of the structure of Fig. 18 expanded into the four quadrants, and Fig. 20 is an exploded view. Numeral 224 references the high permeability core. Numeral 270 references the permanent magnet which is composed of three sections integral with one another and with no gaps or other material present between the high permeability core and the magnetic section. The conical section is designated 272, integral with the laterally-extended cylindrical section 274, in turn integral with the outer cylindrical section 276 surrounding a non-magnetic section 278 aligned with the longitudinal z axis. The yoke, as in the earlier applications, is a C-shaped soft magnetic structure comprising arms 162, 164 connected by a bight 160. The Fig. 20 view is depicted as if the whole structure was lifted out of the yoke bight 160 and then exploded. The Fig. 21 embodiment shows one quadrant corresponding to Fig. 18 cut out and removed to show the inner construction. As will be observed, with the structure lying on its base represented by the yoke bight 60, due to the circular-symmetry, the patient can be introduced into the cavity from both sides as well as from the top, as the shoulder cavity 234 surrounds the smaller head cavity 203 bounded by the pole piece surfaces 4. The patient is positioned for head NMR imaging with its head inside the cavity 203 and its shoulders extending into the cavity 234. The magnet configuration described will generate a uniform imaging field in a region of interest surrounding the patient's head, the magnetic field having an intensity $H_0$ along the z axis in Fig. 20.

As with the embodiments of the related applications, it will be appreciated that the embodiment of Fig. 18 represent only one quadrant of the structure. The full structure is obtained as illustrated in Figs. 20 and 21 by rotating that quadrant about the vertical and horizontal axes originating at the origin 0, and thus expanded to include both upper right (shown in Fig. 18) and left quadrants, to form a circular-symmetrical magnetic structure 142, spaced opposite to an identical structure 144 corresponding to the lower right and left quadrants.

A variation of the embodiment of Fig. 18 is illustrated and described in Fig. 3.3 of Appendix B, where an external pole piece may be placed on the lower surface of the cylindrical section 274 (extending laterally from $P_1$ in Fig. 3.3). In the calculation in Table I of Appendix B, the external pole piece is assumed to have a thickness of 20 mm. The effect of varying the thickness is illustrated in Table II of Appendix B for a hole radius of 65 mm.

Those skilled in the art will appreciate that the invention is not necessarily limited to structures with the dimensions indicated in the drawings, which are only to illustrate the size of a particular embodiment. The preferred geometry illustrated can be replaced by other geometries following the principles described herein as described above.

While the invention has been described in connection with preferred embodiments, it will be understood that modifications thereof within the principles outlined above will be evident to those skilled in the art and thus the invention is not limited to the preferred embodiments but is intended to encompass such modifications.

## Claims

1. A magnetic structure for generating a substantially uniform magnetic field capable of implementing NMR imaging of the head of a patient within a region of interest, comprising:

   a) first (42) and second (44) magnetic structures defining a first cavity (32) having the region of interest and configured to accommodate the head of a patient and defining adjacent the first cavity a second cavity (34), larger than the first cavity, configured to accommodate the shoulders of the patient when the latter's head is positioned in the first cavity, the first and second magnetic structures being positioned on opposite sides of the first and second cavities and defining a common longitudinal axis (z) through the centers of the first and second magnetic structures and providing access from the outside for surgical intervention to the head of the patient when positioned within the first cavity,
       **characterized in that**:
   b) each of the first and second magnetic structures comprises a conically-shaped permanent magnetic section (26, 110, 172) having a conical axis and having a narrow end adjacent the first cavity and a wide end remote from the first cavity, each of said conically-shaped magnetic sections being configured to produce within the region of interest in the first cavity a substantially uniform magnetic field (H) capable of implementing NMR imaging,
   c) each of the first and second magnetic structures further comprising adjacent their respective conically-shaped magnetic sections a first cylindrical magnetic section (20, 120, 174) having a longitudinal axis coincident with the common longitudinal axis,
   d) the conically-shaped magnetic sections and the first cylindrical magnetic sections being configured to extend the substantially uniform field within the region of interest to the second cavity such that the uniformity of the magnetic field in the region of interest remains capable of implementing NMR imaging.

2. A magnetic structure for generating a uniform magnetic field capable of implementing NMR imaging of the head of a patient within a region of interest as claimed in claim 1,
   **characterized in that**:

   the first and second magnetic sections are configured such that the second cavity surrounds the first cavity.

3. A magnetic structure for generating a uniform magnetic field capable of implementing NMR imaging of the head of a patient within a region of interest as claimed in claims 1 or 2,
   **characterized in that**:

   the first cylindrical magnetic section is annular.

4. A magnetic structure for generating a uniform magnetic field capable of implementing NMR imaging of the head of a patient within a region of interest as claimed in any one of claims 1-3, **characterized in that**:

   both the first and second magnetic structures are circular symmetric about the common longitudinal axis.

5. A magnetic structure for generating a uniform magnetic field capable of implementing NMR imaging of the head of a patient within a region of interest as claimed in any one of claims 1-4, **characterized in that**:

   the conically-shaped magnetic sections are hollow having a conical axis coaxial with the common longitudinal axis, the cylindrical magnetic sections having a longitudinal axis coaxial with the common longitudinal axis.

6. A magnetic structure for generating a uniform magnetic field capable of implementing NMR imaging of the head of a patient within a region of interest as claimed in claim 5,
   **characterized in that**:

   each of the first and second magnetic structures further comprises a high permeability ferromagnetic member (24, 12) filling the hollow within the conically-shaped magnetic sections, each of the high permeability ferromagnetic members have a flat first surface (48, 198, 4) adjacent the first cavity.

7. A magnetic structure for generating a uniform magnetic field capable of implementing NMR imaging of the head of a patient within a region of interest as claimed in claim 6,
   **characterized in that**:

   the narrow end ($P_0$, C10) of the conically-shaped magnetic section is in the same plane as the flat first surface of the ferromagnetic member.

8. A magnetic structure for generating a uniform magnetic field capable of implementing NMR imaging of the head of a patient within a region of interest as claimed in claim 6,
**characterized in that**:

the high permeability ferromagnetic member filling the hollow within the conically-shaped magnetic sections and the latter together form a truncated conical section comprising an outer coaxial conical section having half angles $\theta_1$ and $\theta_0$ and an inner coaxial conical section comprising the high-permeability ferromagnetic member,
the half angles $\theta_1$ and $\theta_0$ being selected such that the desired substantially uniform field in the first and second cavities is achieved.

9. A magnetic structure for generating a uniform magnetic field capable of implementing NMR imaging of the head of a patient within a region of interest as claimed in claim 8,
**characterized in that**:

the half angles $\theta_1$ and $\theta_0$ have values of about 20° and 45° respectively.

10. A magnetic structure for generating a uniform magnetic field capable of implementing NMR imaging of the head of a patient within a region of interest as claimed in any one of claim 1-9, **characterized in that**:

the substantially uniform magnetic field is oriented in a direction parallel to the common longitudinal axis, and the remanences (16, 22, 122, J) of both the conically-shaped magnetic sections and the first cylindrical magnetic structures are also oriented in a direction parallel to the common longitudinal axis.

11. A magnetic structure for generating a uniform magnetic field capable of implementing NMR imaging of the head of a patient within a region of interest, comprising:

a) first and second magnetic structures (142,144) defining a first cavity (132) having the region of interest and configured to accommodate the head of a patient and defining adjacent the first cavity a second cavity (134), larger than the first cavity, configured to accommodate the shoulders of the patient when the latter's head is positioned in the first cavity, the first and second magnetic structures being positioned on opposite sides of the first and second cavities and defining a common longitudinal axis (z) through the centers of the first and second magnetic structures and providing access if desired from the outside for surgical intervention to the head of the patient when positioned within the first cavity,
**characterized in that**:

b) each of the first and second magnetic structures comprise a magnetic structure including:

i) an annular section of permanent magnetic material and having a conical portion (172) having a narrow end and a wide end and substantially inner (5) and outer (8) conical surfaces and a conical axis coincident with the common longitudinal axis, the narrow end being positioned closer to the region of interest than the wide end, the permanent magnetic section having a first value and a first orientation of remanence (J),
ii) a pole piece member (12) of ferromagnetic material and positioned within the conical section adjacent and bordering its inner conical surface and having an axis also coincident with the common longitudinal axis, the annular surface of contact (C1-C10) between the inner conical surface of the permanent magnetic section and the bordering pole piece member being slightly curved,

c) the permanent magnetic sections and the pole piece members of the first and second magnetic structures cooperating to produce within the first cavity a substantially uniform magnetic field capable of supporting NMR imaging,
d) the shape of the annular curved surface of contact being configured so as to form at that surface an equipotential surface, whereby distortion of the substantially uniform magnetic field is minimized.

12. A magnetic structure as claimed in claim 11,
**characterized in that**:

each of the permanent magnetic sections of the first and second magnetic structures further comprises a first cylindrical magnetic section (174) extending radially in a direction away from the common longitudinal axis and integral with the conical portion.

13. A magnetic structure as claimed in claims 11 or 12,
**characterized in that**:

each of the pole piece members have an inner surface (4) bounding the first cavity and an outer surface remote from the first cavity, each of the permanent magnetic sections of the first and second magnetic structures further comprising a second cylindrical magnetic section (176) integral with the first cylindrical magnetic section and extending over the outer surface of the adjacent pole piece member.

14. A magnetic structure as claimed in claim 13, **characterized in that**:

    the conical portion and the first and second cylindrical magnetic sections of each of the first and second magnetic structures form a one-piece integral permanent magnetic body.

15. A magnetic structure as claimed in claim 14, **characterized in that**:

    the one-piece integral permanent magnetic body of each of the first and second magnetic structures is magnetized (J) with an orientation parallel to the common longitudinal axis.

16. A magnetic structure as claimed in any one of claims 13-15, **characterized in that**:

    each of the second cylindrical magnetic sections bound a non-magnetic region (178) aligned with the common longitudinal axis.

17. A magnetic structure as claimed in claim 16, **characterized in that**:

    the non-magnetic regions of each of the second cylindrical magnetic sections are positioned at predetermined locations selected such as to establish magnetostatic potentials that support the substantially uniform magnetic field.

18. A magnetic structure as claimed in claim 11, **characterized in that**:

    the annular curved surface of contact is concave and faces away from the common longitudinal axis.

19. A magnetic structure as claimed in any one of claims 11-18, **characterized in that**:

    the first and second magnetic structures are configured such that the second cavity surrounds the first cavity and both the first and second magnetic structures are circular symmetric about the common longitudinal axis.

20. A magnetic structure as claimed in any one of claims 1-19, **characterized in that**:

further comprising a yoke magnetically connected to the first and second magnetic structures.

21. A magnetic structure as claimed in any one of claims 1-19, **characterized in that**:

    further comprising a yoke that is C-shaped having arms connected by a bight with the arms magnetically connected to the side of the cylindrical permanent magnet sections remote from the first cavity.

22. A magnetic structure as claimed in any one of claims 1-21, **characterized in that**:

    further comprising compensation means (80, 185, 187) on the outer surfaces of the conical permanent magnetic sections configured to compensate any distortion of the imaging field.

23. A magnetic structure as claimed in claims 6 or 11, **characterized in that**:

    the ferromagnetic member of each of the first and second magnetic structures has a high permeability and a generally conical shape.

24. A magnetic structure for generating a uniform magnetic field capable of implementing NMR imaging of the head of a patient within a region of interest as claimed in any one of claims 1-6, **characterized in that**:

    each of the first and second magnetic structures further comprises a second cylindrical magnetic structure (30) positioned on the side of the ferromagnetic member remote from the first cavity.

25. A magnetic structure for generating a uniform magnetic field capable of implementing NMR imaging of the head of a patient within a region of interest as claimed in claim 24, **characterized in that**:

    the second cylindrical magnetic structure of each of the first and second magnetic structures extends laterally across substantially the whole magnetic structure.

26. A magnetic structure as claimed in claim 22, **characterized in that**:

    the compensation means comprise shimming means for reducing field distortions in or near the region of interest, said shimming means comprising:

A) at least a first radially magnetized ring positioned on the outer conical surface of the conical section at its bottom, said first ring being configured to reduce field distortion.

27. A magnetic structure as claimed in claim 26, **characterized in that**:

the compensation means further comprise at least a second radially magnetized ring positioned on the outer conical surface of the conical section axially spaced from the first ring, the magnetic orientations of the first and second rings being in anti-parallel relationship.

28. A magnetic structure for generating a uniform magnetic field capable of implementing NMR imaging of the head of a patient within a region of interest as claimed in any one of claims 6-10, **characterized in that**:

each of the high permeability ferromagnetic members further comprises a lateral extension (28) positioned on the side of the first cylindrical magnetic structure remote from the second cavity.

29. A magnetic structure for generating a uniform magnetic field capable of implementing NMR imaging of the head of a patient within a region of interest as claimed in claim 28, **characterized in that**:

each of the first and second magnetic structures further comprises a non-magnetic insert (32) between the wide end of the conically-shaped magnet section and the adjacent side of the first cylindrical magnetic section, the non-magnetic insert having a triangular cross-section that has a magnetic field intensity oriented in a direction opposite to the orientation of the remanences of both the conically-shaped magnetic section and the first cylindrical magnetic section.

30. A magnetic structure for generating a uniform magnetic field capable of implementing NMR imaging of the head of a patient within a region of interest as claimed in any one of claims 1-5, **characterized in that**:

further comprising transition means (108,116) for interfacing the wide end of the conical section and the adjacent end of the first cylindrical magnetic section for at least partially correcting for field distortion in or near the region of interest arising from the magnetic coupling between the wide end of the conical section and the adjacent end of the first cylindrical magnetic section.

31. A magnetic structure as claimed in claim 30, **characterized in that**:

the transition means is constituted by at least one magnetic strap (108) extending radially within the first cylindrical section to force surfaces therein intended to be equipotential to become more equipotential.

32. A magnetic structure as claimed in claim 31, **characterized in that**:

the magnetic strap extends up to but spaced (116) from the inner surface (130) of the conical section.

33. A magnetic structure as claimed in any one of claims 1-32, **characterized in that**:

the magnetic properties and configuration of the conical section and first cylindrical section are based on an initial selected design factor K, the magnetic structure being actually configured on the basis of a design factor K selected to have a value slightly larger than the factor originally used in the design such that the field uniformity in the region of interest is improved.

34. A magnetic structure as claimed in any one of claims 30-33, **characterized in that**:

the magnetic structures comprise a second cylindrical magnetic section (172, 174) overlying the first cylindrical magnetic section, the ferromagnetic pole piece member is recessed (170), and the second cylindrical magnetic section has an inwardly extending section (172) that extends into the recess of the ferromagnetic pole piece member.

35. A magnetic structure as claimed in claim 34, **characterized in that**:

each of the first and second magnetic structures further comprises a magnetic strap (132) extending radially between the first cylindrical magnetic structure and a section of the second cylindrical magnetic section spaced from the inwardly extending section.

**36.** A magnetic structure as claimed in claim 35, **characterized in that**:

further comprising a soft ferromagnetic section (178) interconnecting the magnetic strap and the ferromagnetic pole piece along the inner surface of the conical section.

**37.** A magnetic structure as claimed in claim 14, **characterized in that**:

further comprising a soft ferromagnetic pole piece located on the side of the first cylindrical magnetic section adjacent the second cavity.

**38.** A method of designing a magnetic structure for generating a uniform magnetic field capable of implementing NMR imaging of the head of a patient within a region of interest, the magnetic structure comprising:

a) first and second magnetic structures defining a first cavity having the region of interest and configured to accommodate the head of a patient and defining adjacent the first cavity a second cavity, larger than the first cavity, configured to accommodate the shoulders of the patient when the latter's head is positioned in the first cavity, the first and second magnetic structures being positioned on opposite sides of the first and second cavities and defining a common longitudinal axis through the centers of the first and second magnetic structures and providing access from the outside for surgical intervention to the head of the patient when positioned within the first cavity,

b) each of the first and second magnetic structures comprising a magnetic structure including:

i) an annular conical section of permanent magnetic material and having a narrower end and a wider end connected by inner and outer substantially conical surfaces and a conical axis coincident with the common longitudinal axis, the narrower end being positioned closer to the region of interest than the wider end,

ii) an inner essentially cylindrical magnetic section of permanent magnetic material and having a longitudinal axis coincident with the common longitudinal axis and adjacent and magnetically coupled to the wider end of the conical section, the inner cylindrical magnetic section extending radially in a direction away from the common longitudinal axis,

iii) transition means for interfacing the wider end of the conical section and the adjacent end of the inner cylindrical magnetic section for at least partially correcting for field distortion in or near the region of interest arising from the magnetic coupling between the wider end of the conical section and the adjacent end of the inner cylindrical magnetic section,

iv) a pole piece member of ferromagnetic material and positioned within the conical section adjacent its inner surface and having an axis also coincident with the common longitudinal axis,

v) an outer cylindrical permanent magnetic section having an axis coincident with the common longitudinal axis and extending over the inner cylindrical magnetic section and the ferromagnetic pole piece member;

**characterized in that**:
the method steps comprise:

A) initially selecting a design factor K for configuring the magnetic properties and configuration of magnetic components including the conical section, the inner and outer cylindrical magnetic sections, and the transition means,

B) measuring the field uniformity in the region of interest for values of K that differ by no more than 10% from the initially selected design factor K,

C) reconfiguring the magnetic components using that value of K taken from the measurements made during step B) that shows the greatest uniformity.

**39.** A method as claimed in claim 38, **characterized in that**:

the value of K chosen in step C) is larger than the initially selected design factor K by between 2 and 4 %.

**40.** A method of designing a magnetic structure for generating a uniform magnetic field capable of implementing NMR imaging of the head of a patient within a region of interest, the magnetic structure comprising:

a) first and second magnetic structures defining a first cavity having the region of interest and configured to accommodate the head of a patient and defining adjacent the first cavity a second cavity, larger than the first cavity, configured to accommodate the shoulders of the patient when the latter's head is positioned in the first cavity, the first and second magnetic structures being positioned on opposite sides of the first and second cavities and defining a common longitudinal axis through the centers of the first and second magnetic structures and providing access from the outside for surgical intervention to the head of the patient when positioned within the first cavity,

b) each of the first and second magnetic structures comprising a magnetic structure including:

i) an annular conical section of permanent magnetic material and having a narrower end and a wider end connected by inner and outer substantially conical surfaces and a conical axis coincident with the common longitudinal axis, the narrower end being positioned closer to the region of interest than the wider end,

ii) an inner essentially cylindrical magnetic section of permanent magnetic material and having a longitudinal axis coincident with the common longitudinal axis and adjacent and magnetically coupled to the wider end of the conical section, the inner cylindrical magnetic section extending radially in a direction away from the common longitudinal axis,

iii) transition means for interfacing the wider end of the conical section and the adjacent end of the inner cylindrical magnetic section for at least partially correcting for field distortion in or near the region of interest arising from the magnetic coupling between the wider end of the conical section and the adjacent end of the inner cylindrical magnetic section,

iv) a pole piece member of ferromagnetic material and positioned within the conical section adjacent its inner surface and having an axis also coincident with the common longitudinal axis,

v) an outer cylindrical permanent magnetic section having an axis coincident with the common longitudinal axis and extending over the inner cylindrical magnetic section and the ferromagnetic pole piece member;

**characterized in that**:
the method steps comprise:

A) constructing at least first rings of permanent magnetic material dimensioned to surround and contact the outer conical surfaces of both conical sections,

B) magnetizing the first rings such that when positioned on the conical magnets, the orientation of their remanence is radial and perpendicular to the longitudinal axis,

C) placing the first rings on the outer conical surface at its bottom vertex of both conical sections,

D) if necessary, reconfiguring the first rings or adding second rings to the conical sections to further reduce field distortions.

41. A method of shimming a magnetic structure for generating a uniform magnetic field capable of implementing NMR imaging of the head of a patient within a region of interest as claimed in claim 40,
    **characterized in that**:
    further comprising the steps:

E) measuring the magnetic field uniformity over a reference sphere (195) having an origin at the structure center and co-spherical with the region of interest before step C,

F) re-measuring the magnetic field uniformity over the reference sphere having an origin at the structure center and co-spherical with the region of interest after step C,

G) in step D, reconfiguring the rings based on the measurements of steps E and F to reduce distortion.

42. A method of shimming a magnetic structure for generating a uniform magnetic field capable of implementing NMR imaging of the head of a patient within a region of interest as claimed in claim 41,
    **characterized in that**:

at least second rings (189, 19 1) are added, the rings all being magnetized radially and being in inverted magnetic orientation relationship.

43. A method of designing a magnetic structure for generating a uniform magnetic field capable of implementing NMR imaging of the head of a patient within a region of interest, the magnetic structure comprising:

a) first and second magnetic structures defining a first cavity having the region of interest and configured to accommodate the head of a patient and defining adjacent the first cavity a second cavity, larger than the first cavity, configured to accommodate the shoulders of the patient when the latter's head is positioned in the first cavity, the first and second magnetic structures being positioned on opposite sides of the first and second cavities and defining a common longitudinal axis through the centers of the first and second magnetic structures and providing access if desired from the outside for surgical intervention to the head of the patient when positioned within the first cavity,

b) each of the first and second magnetic structures comprising a magnetic structure including:

 i) an annular section of permanent magnetic material and having a conical portion having a narrower end and a wider end and substantially inner and outer conical surfaces and a conical axis coincident with the common longitudinal axis, the narrower end being positioned closer to the region of interest than the wider end,

 ii) a pole piece member of ferromagnetic material and positioned within the conical section adjacent and bordering its inner conical surface and having an axis also coincident with the common longitudinal axis, the annular surface of contact between the inner conical surface of the permanent magnetic section and the bordering pole piece member being slightly curved,

c) the permanent magnetic sections and the pole piece members of the first and second magnetic structures cooperating to produce within the first cavity a substantially uniform magnetic field capable of supporting NMR imaging,

 **characterized in that**:
 the steps comprise:

A) chosing the head and shoulder cavity dimensions that will accommodate the head and shoulders of an average patient;

B) chosing suitable angles of the conical surfaces to accommodate the shoulders of the patient and not extend unnecessarily the overall dimensions of the structure;

C). chosing permanent magnetic material to use which determines its remanence J which with a typical value of K determines the desired uniform field intensity $H_0$ in the first cavity;

D) the coordinates of a point C10 on the annular surface of contact adjacent the first cavity and the magnetostatic potential $\Phi$ at that point being determined by the choices made in steps A-C;

E) maintaining constant the magnetostatic potential $\Phi$ determined in step D, determining the coordinates for at least several more points along the annular surface of contact to determine a profile for the annular surface of contact;

F) constructing the annular section of permanent magnetic material using the profile determined in step E and assembling to the remainder of the magnetic structure.

**44.** A method of designing a magnetic structure for generating a uniform magnetic field as claimed in claim 43,

 **characterized in that**:

 E) step E is carried out by calculation from Equation 2.1 for $\Phi = C_0$.

**45.** A method as set forth in claim 44,
 **characterized in that**:
 further comprising the step:

 H) before step F, repeating step E to determine the shape of the upper part of the annular section of permanent magnetic material to be assembled to the remainder of the magnetic structure, step H) comprising:.

 I) providing an opening in the upper part of the annular section of permanent magnetic material adjacent the longitudinal axis, the opening being positioned to minimize field distortions in the region of interest;

 J) shaping the outer surface of the pole piece member of ferromagnetic material to conform to the profile determined in step E.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

EP 1 462 816 A2

FIG. 20

FIG. 21